# EUROPÄISCHE PATENTSCHRIFT

(11) **EP 0 995 637 B1**
(45) Veröffentlichungstag und Bekanntmachung des Hinweises auf die Patenterteilung: **23.03.2005**
(21) Anmeldenummer: 99120200.3
(22) Anmeldetag: 09.10.1999
(51) Int. Cl.: B60R 16/02

(54) **Einrichtung zur Speicherung von Daten in einem Kraftfahrzeug**
Device for storing data in a motor vehicle
Dispositif de stockage de données dans un véhicule automobile

(30) Priorität: 19.10.1998 DE 19848090
(43) Veröffentlichungstag der Anmeldung: 26.04.2000
(73) Patentinhaber: Siemens Aktiengesellschaft, 80333 München (DE)
(72) Erfinder: Hartmann, Stefan, 55278 Hahnheim (DE); Gnatzy, Dieter, 65239 Hochheim (DE); Hohrein, Stefan, 55126 Mainz (DE)

(56) Entgegenhaltungen:
- DE-A- 19 625 619
- DE-A- 19 638 973
- DE-A- 19 639 500
- DE-C- 19 740 525
- US-A- 5 701 492

## Beschreibung

Die Erfindung betrifft eine Einrichtung zur Speicherung von Daten einer zu kontrollierenden Vorrichtung, insbesondere eines Kraftfahrzeuges gemäß dem Oberbegriff des Patentanspruchs 1.

Aus der DE 196 25 619 C2 (Oberbegriff von Anspruch 1) ist ein Verfahren zum Abspeichern von Daten in einem Kraftfahrzeug bekannt, bei welchem Adaptionsdaten, die zur Steuerung des Kraftfahrzeuges verwendet werden, zunächst in einen ersten Speicher eingelesen werden und bei Unterschreitung einer vorgegebenen Geschwindigkeit des Kraftfahrzeuges aus diesem Speicher wieder ausgelesen werden und in einen zweiten nichtflüchtigen Speicher abgespeichert werden. Dabei bildet der Speicher, welcher Adaptionsdaten speichert, einen Teilbereich eines Speichers, welcher die Steuer- und Regelprogramme enthält.

Aus der DE 196 38 973 C2 ist ein elektronisches Steuergerät bekannt, bei welchem der Programmspeicher und der Adaptionsdaten enthaltende Speicher auf einem Chip angeordnet sind, zum Beispiel in Form eines blockweise organisierten Festwertspeichers.

Solche Adaptionsdaten sind dabei Steuerdaten, die das Steuerprogramm benötigt, um den Betriebsablauf des Fahrzeuges zu gewährleisten. Während der Lebensdauer eines Steuergerätes ändern sich die Betriebsparameter der vom Steuergerät zu steuernden Vorrichtung, insbesondere des Kraftfahrzeuges. Die Steuerdaten müssen somit laufend neu ermittelt und die neu ermittelten Daten abgespeichert werden. Auf diese Weise wird eine Anpassung der Steuerprogramme an Änderungen der Betriebsparameter der zu steuernden Vorrichtung möglich.

Auf Grund der Entwicklung der Elektronik im Kraftfahrzeug müssen während der Lebensdauer des Fahrzeuges immer mehr Betriebsdaten erzeugt und angepasst werden. Zur Ausführung einer Steuerung des Kraftfahrzeuges werden die entsprechenden Daten aus diesem Schreib-/Lesespeicher aufgerufen und von der zentralen Recheneinheit verarbeitet. Die dabei üblicherweise als Schreib-/Lesespeicher eingesetzten NV-RAM's werden seriell angesteuert, was lange Bearbeitungszeiten nach sich zieht.

Der Erfindung liegt somit die Aufgabe zugrunde, eine Einrichtung anzugeben, die es erlaubt, eine Vielzahl sich während der Lebensdauer des Kraftfahrzeuges permanent ändernder Daten betriebssicher und mit einer hohen Arbeitsgeschwindigkeit zu speichern.

Erfindungsgemäß wird die Aufgabe durch die Merkmale des Patentanspruchs 1 gelöst.

Der Vorteil der Erfindung besteht darin, dass durch die Verwendung eines die Steuer- und Regelprogramme enthaltenen Speichers zur permanenten Speicherung von betriebsabhängigen Steuerdaten des Kraftfahrzeuges auf einen oder mehrere Schreib/Lesespeicher verzichtet werden kann. Der feste Programmcode und die nichtflüchtigen Daten werden in einem einzigen elektrischen Bauteil gespeichert, was eine Hardwarereduzierung zur Folge hat. Diese Hardwarereduzierung ist insbesondere bei den immer komplexer werdenden elektronischen Steuerungen und Regelungen, wie sie im Kraftfahrzeug Anwendung finden, und bei dem immer geringer werdenden Bauraum, der im Kraftfahrzeug zur Verfügung steht, von entscheidendem Vorteil, da dadurch eine entscheidende Kostenreduzierung erreicht wird.

Durch die Verwendung eines fest adressierten Bereiches steht ein überschaubares Speicherplatzkontingent zur Verfügung, was ausschließlich zur zyklischen Abspeicherung von sich ändernden fahrspezifischen Betriebs- und Steuerdaten genutzt wird.

Alternativ dazu können diese Daten in einem von der physikalischen Organisation der Speichereinheit abhängigen Adressraum abgelegt werden.

Bei Nutzung von mindestens zwei Sektoren des definierten Bereiches der Speichereinheit ist gewährleistet, dass vor jedem Löschvorgang ein Schreibvorgang der aktualisierten Daten vorangehen kann.

Dabei wird zunächst der erste Sektor des definierten Bereiches der Speichereinheit vollständig mit den Betriebsdaten beschreiben und erst nachdem die ersten Speicherplätze des zweiten Sektors beschrieben sind, wird der erste Sektor vollständig gelöscht. Damit wird sichergestellt, dass der erste Sektor des definierten Bereiches erst dann gelöscht wird, wenn sichergestellt ist, dass die im zweiten Sektor des definierten Bereiches abgelegten Daten fehlerfrei sind. Im Fehlerfall kann immer noch auf die Daten des ersten Sektors zur Durchführung der Steuer- und Regelungsvorgänge zurückgegriffen werden.

Vorteilhafterweise ist die Speichereinheit ein elektrisch löschbarer Speicherschaltkreis. Zu diesem Zweck können handelsübliche Flash-Bausteine eingesetzt werden.

In einer Ausgestaltung ist die Steuereinheit eine Abstandsregeleinrichtung des Kraftfahrzeuges, welche als betriebsabhängige Daten sowohl Objektdaten als auch fahrzeugdynamische Daten in einem vorgegebenen Zeitraster abspeichert. Durch die Verwendung der erfindungsgemäßen Speichermöglichkeit bei einer solchen Abstandsregelung wird die Zykluszeit trotz einer Vielzahl von zu speichernden Daten wie beispielsweise Abstand und Relativgeschwindigkeit der vorausfahrenden Fahrzeuge, Koordinaten des Fahrkorridors, Geschwindigkeit und Beschleunigung des zu regelnden Kraftfahrzeuges um ein Vielfaches gesteigert.

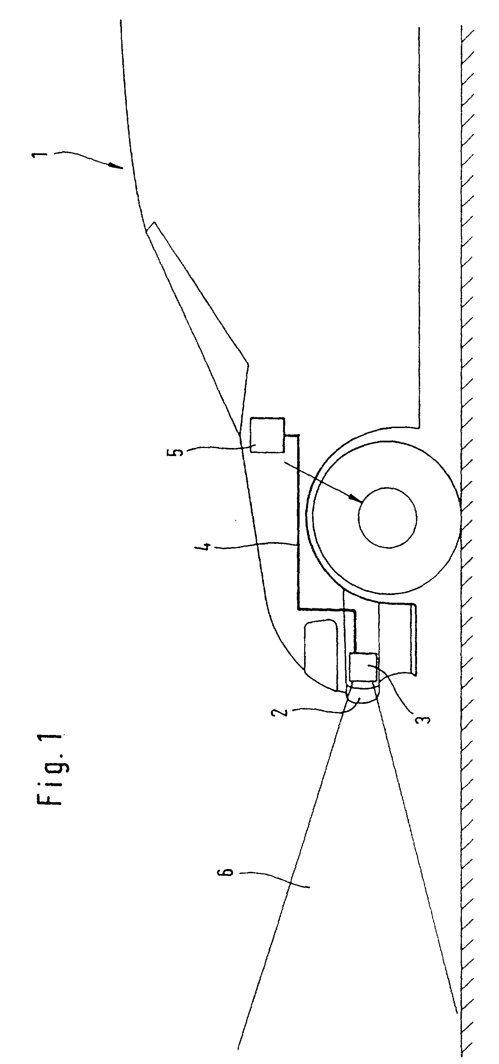

Die Erfindung lässt zahlreiche Ausführungsformen zu. Eine davon soll anhand der in der Zeichnung dargestellten Figuren näher erläutert werden. Es zeigt:
- Figur 1:: Abstandsregeleinrichtung in einem Kraftfahrzeug
- Figur 2:: prinzipieller Aufbau der Abstandsregeleinrichtung
- Figur 3:: elektrische Anordnung der Abstandsregeleinrichtung Im Kraftfahrzeug
- Figur 4:: Speicherdarstellung.
Gleiche Merkmale sind mit gleichen Bezugszeichen gekennzeichnet. In Figur 1 ist an dem Stoßfänger 2 eines Kraftfahrzeuges 1 ein automatisches Abstands- und Geschwindigkeitsregelsystem 3 zur Einhaltung des Sicherheitsabstandes von Fahrzeugen angeordnet. Über ein im Fahrzeug 1 vorhandenes Bussystem 4 ist das automatische Abstands- und Geschwindigkeitsregelsystem 3 beispielsweise mit der Motorsteuerung 5 verbunden. Elektronische Befehle regulieren automatisch die Geschwindigkeit und somit den Abstand des zu regelnden Fahrzeuges 1 zu einem vorausfahrenden, langsameren Fahrzeug. Das vorausfahrende Fahrzeug wird durch den Sensorstrahl 6 eines Radarsensors 7 des Abstands- und Geschwindigkeitsregelsystems 3 erfasst.

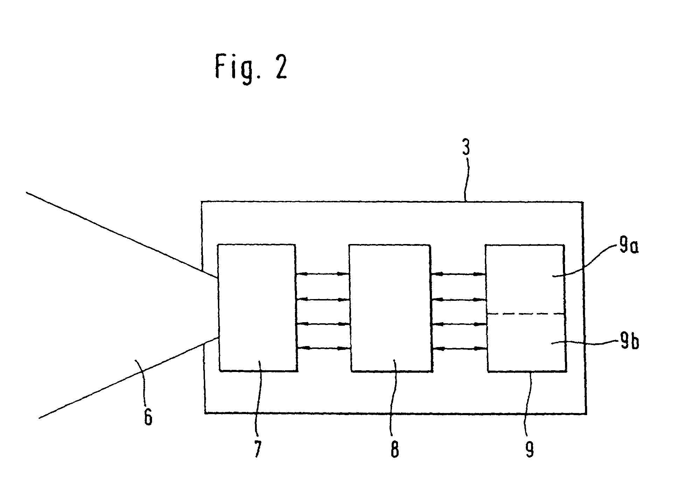

Wie in Figur 2 dargestellt, bildet das automatische Abstandsund Geschwindigkeitsregelsystem eine bauliche Einheit 3 zwischen Sensor 7, Sensorsignalaufbereitungsanordnung 8 und Abstandsregelsystem 9.

Das Abstandsregelsystem 9 weist dabei eine Einrichtung 9a zur Bestimmung einer zukünftigen Fahrspur des Fahrzeuges und einer Objektspur des Vergleichsobjektes sowie einen Längsregler 9b auf, der den tatsächlichen Abstand zu einem Regelobjekt bestimmt, diesen mit einem vorgegebenen, abgespeicherten Sollabstand vergleicht und bei Abweichungen durch Eingriffe in die Motorsteuerung 5, den Sollabstand zum Regelobjekt herstellt.

Der Sensor 7 sendet in regelmäßigen Abständen, z. B. alle 60 ms, in Fahrtrichtung des Fahrzeuges Signale aus, welche von den Fahrzeugen, die sich im Sensorstrahl 6 befinden, reflektiert werden. Aus diesen reflektierten Signalen wird von der Signalaufbereitungsanordnung 8 der Abstand, die Relativgeschwindigkeit und die Beschleunigung des vorausfahrenden Fahrzeuges bestimmt. Diese Messergebnisse werden von der Signalaufbereitungsanordnung 8 an das Abstandsregelsystem 9 weitergegeben. Die Signalaufbereitungsanordnung 8 verarbeitet gleichzeitig Daten von 30 dem Fahrzeug vorausfahrenden Hindernissen.

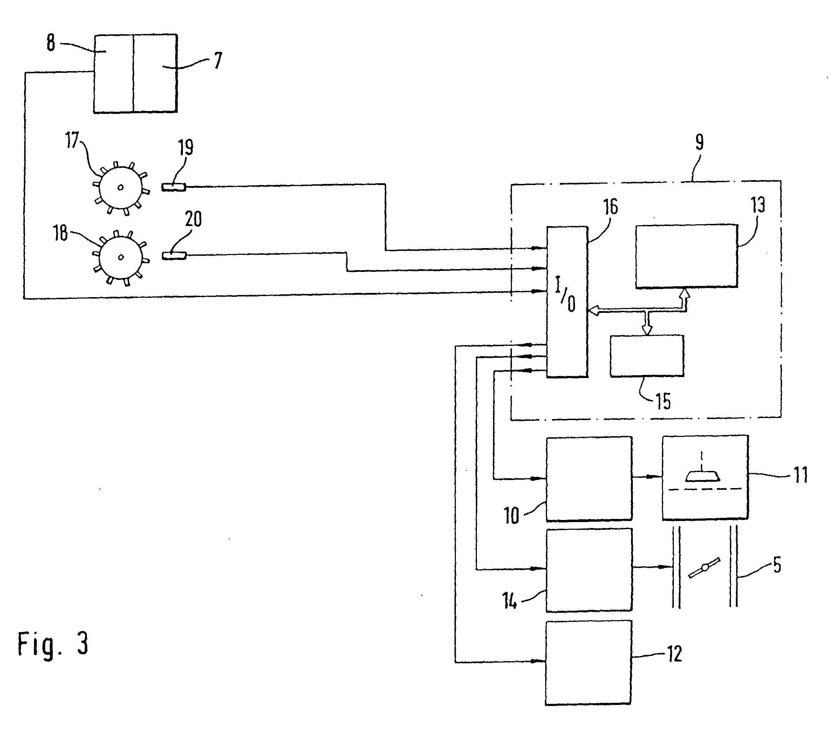

Wie in Figur 3 dargestellt, besteht das Abstandsregelsystem 9 aus einem leistungsstarken Mikrorechner 13, einem Programmspeicher 15 sowie einer Ein-/Ausgabeeinheit 16. Die Ein-/Ausgabeeinheit 16 erhält dabei von der Sensoraufbereitungsanordnung 8, die schon beschriebenen Informationen. Auch die Aufgaben der Fahrspur- und Objektspurbestimmung sowie der Längsregelung werden von dem Mikrorechner 9 übernommen.

Am Fahrzeug selbst sind Inkrementscheiben 17 und 18 an den jeweils beiden nicht weiter dargestellten Vorderrädern angeordnet. Den Inkrementscheiben 17, 18 sind gegenüberliegend Drehzahlsensoren 19, 20 angeordnet. Die von den Drehzahlsensoren 19, 20 detektierten Drehzahlsignale werden ebenfalls über die Ein-/Ausgabeeinheit 16 dem Mikrorechner 9 zugeführt. Der Mikrorechner 9 berechnet daraus unter anderem die Fahrzeuggeschwindigkeit, die Gierrate und den aktuell gefahrenen Kurvenradius.

Bei Annähern an ein langsameres Fahrzeug verzögert der Mikrorechner 9 automatisch die Fahrzeuggeschwindigkeit und regelt so den eingestellten Sollabstand zum vorausfahrenden Fahrzeug. Für das automatische Verzögern sind Einwirkungen auf die Motorsteuerung 5, auf die Bremse 11 und/oder eine Ansteuerung der Getriebesteuerung 12 zur Verringerung der Geschwindigkeit möglich. Die Ansteuerung des Motors 5 und der Bremse 11 erfolgt dabei über je eine elektrische Endstufe 10 und 14. Ist die Fahrspur wieder frei, beschleunigt der Mikrorechner 9 das Fahrzeug 1 auf die eingestellte Wunschgeschwindigkeit. Bei einer Fahrzeugvorausfahrt ist immer die Abstandsregelung aktiv.

Wie bereits erläutert, werden in der vorgestellten Anwendung pro Zeiteinheit eine Vielzahl von Daten erzeugt, die sich ständig ändern und die auch entsprechend abgespeichert werden müssen. Pro Zeiteinheit müssen Objektdaten (Abstand, Relativgeschwindigkeit) und regelspezifische Daten (voraussichtlicher Fahrkorridor des zu regelnden Fahrzeuges, voraussichtlicher Objektkorridor des Regelobjektes) sowie Fahrzeugmesswerte gespeichert werden. Solche Fahrzeugmesswerte sind beispielsweise die Geschwindigkeit des zu regelnden Fahrzeuges und die Beschleunigung.

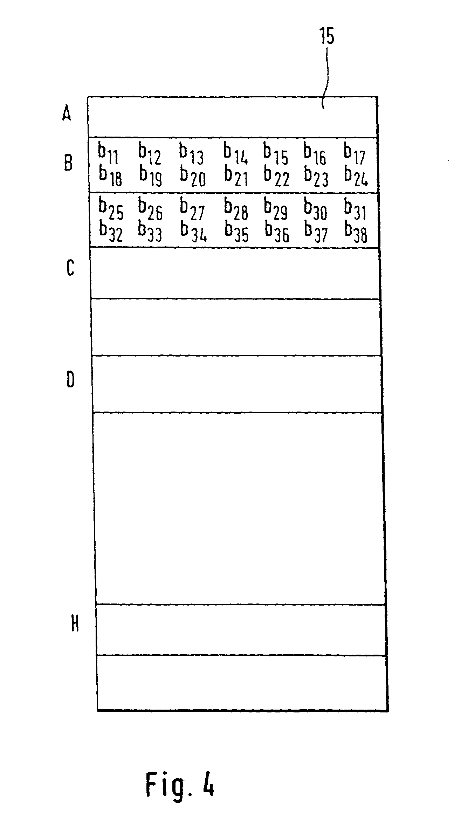

In Figur 4 ist der Schreib-/Lesespeicher 15 näher dargestellt, welcher als Flash-Speicher ausgebildet ist. Der Flash-Speicher 15 ist dabei bidirektional mit der Recheneinheit 13 verbunden. Der Flashspeicher 15 hat in einem Beispiel einen Speicherumfang von 256 KB und ist in 16 Byte langen Blöcken organisiert.

In dem ersten Block A ist der Datenzugriff auf den Speicher definiert. In Block B, der ebenfalls 16 Byte umfasst, ist für die Aufnahme der sich zyklisch ändernden betriebsabhängigen Daten des Kraftfahrzeuges vorgesehen. Die sich an diesen Block anschließenden Blöcke C bis H enthalten Programme zur Berechnung des Fahrkorridors des zu regelnden Fahrzeuges 1, Programme zur Bestimmung des Objektkorridors der vorausfahrenden Fahrzeuge sowie Programme zur Einstellung der Abstandsregelung des zu regelnden Fahrzeuges zu dem ausgewählten Objekt.

Der Block B ist in zwei Sektoren eingeteilt, wobei der erste Sektor die Speicherplätze B11 bis B24 aufweist, während der zweite Sektor die Speicherplätze B25 bis B38 aufweist. Während eines Zeitzyklus liest der Mikrorechner 9 aus den Programmblöcken C bis G die notwendigen Steuerprogramme aus und speichert die für die Regelung notwendigen, verwendeten und berechneten Daten.

In jedem Arbeitszyklus werden die Speicherplätze B11 bis B24 des ersten Sektors des Speichers 15 nacheinander beschrieben. Erst wenn alle Speicherplätze B11 bis B24 des ersten Sektors besetzt sind, werden in den folgenden Zyklen die Speicherplätze B25 bis B29 beschrieben. Erfolgt diese Speicherung fehlerfrei, werden die Speicherplätze B11 bis B24 des ersten Sektors gelöscht. In den sich anschließenden Arbeitszyklen werden die Daten auf den Speicherplätzen B30 bis B38 des zweiten Sektors des Blocks B abgespeichert. Sind alle Speicherplätze B25 bis B38 des zweiten Sektors des Blocks B belegt, werden die aktualisierten Betriebsdaten der Abstandsregelung auf den Speicherplätzen B11 bis B15 des ersten Sektors abgelegt, bevor die Speicherplätze B25 bis B38 des zweiten Sektors zur Aufnahme neuer Daten gelöscht werden.

Auf Grund dieser Arbeitsweise werden die Daten zuverlässig gespeichert, und bei Auftreten eines Fehlers kann immer auf einen schon vorhandenen Datensatz zurückgegriffen werden. Zum anderen können die älteren Daten gelöscht werden, da aktuellere Daten für den Fehlerfall zur Verfügung stehen. Auf Grund der erfindungsgemäßen Vorgehensweise ist es möglich, die Zugriffszyklen auf die Speicherplätze während eines Einsatzes über die Lebensdauer (ca. 100 000 mal Klemme 15 EIN/Aus) eines Kraftfahrzeuges zu garantieren, obgleich die Anzahl der zulässigen Schreib-/Löschzyklen von einer einzelnen Speicherzelle innerhalb der Speichereinheit wesentlich geringer ist, als die während der Lebensdauer eines Kraftfahrzeuges tatsächlich notwendigen Schreib-/Löschzyklen.

Besitzt z. B. eine einzelne Speicherzelle innerhalb der Speichereinheit eine zulässige Anzahl von x Schreib/Löschzyklen, so wird die Anzahl der insgesamt möglichen Schreib-/Löschzyklen bei einer Aufteilung in n Speichersektoren auf die Zahl von x · n Schreib-/Löschzyklen der entsprechenden Daten erhöht.

Die Erfindung beschränkt sich nicht nur auf den beschriebenen Fall der Abstandsregelung bei einem Kraftfahrzeug, sondern ist für alle Steuer- und Regeleinrichtungen einer Brennkraftmaschine einsetzbar.

So ist es auch denkbar, dass der Speicher im Fertigungsprozess des Steuergerätes zur Speicherung von Produktionsdaten genutzt wird, welche von einem Prüfrechner direkt in den Speicherbaustein eingelesen werden.

## Patentansprüche

1. Einrichtung zur Speicherung von betriebsabhängigen Daten einer zu kontrollierenden Vorrichtung, insbesondere eines Kraftfahrzeuges, bei welcher die betriebsabhängigen Daten über eine Steuereinheit (3) in einer Speichereinheit (15) abgespeichert werden, **dadurch gekennzeichnet, dass** ein fester Programmcode und die laufend aktualisierten, betriebsabhängigen Daten der zu kontrollierenden Vorrichtung (1) in der einzigen, Steuerund/oder Regelabläufe enthaltenden, Speichereinheit (15) abgelegt sind, wobei die betriebsabhängigen Daten in einem fest durch eine Adresse der einzelnen Speicherplätze (B11 bis B38) definierten Bereich (B), der in zwei Sektoren (B11 bis B24; B25 bis B38) unterteilt ist, abgelegt sind, und wobei erst ein erster Sektor (B11 bis B24) des definierten Bereiches (B) vollständig mit den betriebsabhängigen Daten beschrieben wird und, wenn alle Speicherplätze (B11 bis B24) des ersten Sektors besetzt sind, die ersten Speicherplätze (B25 bis B29) eines zweiten Sektors (B25 bis B38) beschrieben werden und, sofern diese Speicherung fehlerfrei erfolgt, die Speicherplätze des ersten Sektors (B11 bis B24) vollständig gelöscht werden und anschließend die betriebsabhängigen Daten auf den Speicherplätzen des zweiten Sektors (B30 bis B38) abgespeichert werden.

2. Einrichtung nach Anspruch 1, **dadurch gekennzeichnet, dass** nachdem alle Speicherplätze des zweiten Sektors (B25 bis B38) belegt sind, die betriebsabhängigen Daten auf den Speicherplätzen (B11 bis B15) des ersten Sektors (B11 bis B24) abgelegt werden, bevor die Speicherplätze des zweiten Sektors (B25 bis B38) zur Aufnahme neuer betriebsabhängiger Daten gelöscht werden.

3. Einrichtung nach einem der vorhergehenden Ansprüche, **dadurch gekennzeichnet, dass** die Speichereinheit (15) ein elektrisch löschbarer Speicherschaltkreis ist.

4. Einrichtung nach Anspruch 1, **dadurch gekennzeichnet, dass** die Steuereinheit eine Abstandsregeleinrichtung (3) des Kraftfahrzeuges (1) ist, welche als Betriebsdaten Objektdaten und fahrzeugdynamische Daten in einem vorgegebenen Zeitraster in der Speichereinheit (15) abspeichert.

## Claims

1. Device for storing operation-dependent data of an apparatus to be monitored, in particular a motor vehicle, in which device the operation-dependent data is stored in a memory unit (15) by means of a control unit (3), **characterized in that** a fixed program code and the continuously updated, operation-dependent data of the apparatus (1) to be monitored are stored in the single memory unit (15) which contains control and/or adjustment processes, wherein the operation-dependent data is stored in an area (B) which is permanently defined by an address of the individual memory locations (B11 to B38) and which is divided into two sectors (B11 to B24; B25 to B38), and wherein the operation-dependent data is firstly written completely into a first sector (B11 to B24) of the defined area (B), and if all the memory locations (B11 to B24) of the first sector are occupied the first memory locations (B25 to B29) of a second sector (B25 to B38) are written to, and if this storage is carried out without faults the memory locations of the first sector (B11 to B24) are cleared completely and the operation-dependent data is then stored at the memory locations of the second sector (B30 to B38).

2. Device according to Claim 1, **characterized in that** after all memory locations of the second sector (B25 to B38) are occupied, the operation-dependent data is stored at the memory locations (B11 to B15) of the first sector (B11 to B24) before the memory locations of the second sector (B25 to B38) are cleared in order to receive new operation-dependent data.

3. Device according to one of the preceding claims, **characterized in that** the memory unit (15) is a memory circuit which can be cleared electrically.

4. Device according to Claim 1, **characterized in that** the control unit is a distance-regulating device (3) of the motor vehicle (1) which stores, as operating data, object data and vehicle dynamic data in a predefined time pattern in the memory unit (15).

## Revendications

1. Dispositif permettant de stocker des données dépendant du fonctionnement d'un système à contrôler, notamment d'un véhicule automobile, dans lequel les données dépendant du fonctionnement sont stockées, par l'intermédiaire d'une unité de commande (3) dans une unité de mémoire (15), **caractérisé par le fait qu'**un code fixe de programme et les données dépendant du fonctionnement et actualisées en permanence du système à contrôler (1) sont stockés dans l'unique unité de mémoire (15), qui renferme les programmes de commande et/ou de régulation, les données dépendant du fonctionnement étant stockées dans une zone (B), qui est partagée en deux secteurs (B11 à B24; B25 à B38), définie d'une façon fixe par une adresse des différents emplacements de mémoire (B11 à B38), et le premier secteur (B11 à B24) de la zone définie (B) étant d'abord chargé complètement avec les données dépendant du fonctionnement et, lorsque tous les emplacements de mémoire (B11 à B24) du premier secteur sont occupés, les premiers emplacements de mémoire (B25 à B29) d'un deuxième secteur (B25 à B38) sont chargés et, dans la mesure où cette mémorisation a lieu sans erreur, les emplacements de mémoire du premier secteur (B11 à B24) étant effacés complètement et, ensuite, les données dépendant du fonctionnement étant stockées sur les emplacements de mémoire du deuxième secteur (B30 à B38).

2. Dispositif selon la revendication 1 **caractérisé par le fait que**, une fois tous les emplacements de mémoire du deuxième secteur (B25 à B38) occupés, les données dépendant du fonctionnement sont emmagasinées sur les emplacements de mémoire (B11 à B15) du premier secteur (B11 à B24), avant que les emplacements de mémoire du deuxième secteur (B25 à B38) soient effacés pour recevoir de nouvelles données dépendant du fonctionnement.

3. Dispositif selon l'une des revendications précédentes **caractérisé par le fait que** l'unité de mémoire ( 15) est un circuit logique de mémoire effaçable électriquement.

4. Dispositif selon la revendication 1 **caractérisé par le fait que** l'unité de commande est un dispositif de régulation de l'espacement (3) du véhicule automobile (1), lequel stocke, en une trame de temps donnée, dans l'unité de mémoire (15), en tant que données de fonctionnement, des données d'objet et des données relatives à la dynamique du véhicule.
